# EUROPEAN PATENT SPECIFICATION

(11) **EP 3 274 312 B1**
(45) Date of publication and mention of the grant of the patent: **02.10.2024**
(21) Application number: 15712257.3
(22) Date of filing: 24.03.2015
(51) Int. Cl.: C03C 17/34, C08J 7/00

(54) **FABRICATION OF NANOSTRUCTURES IN AND ON ORGANIC AND INORGANIC SUBSTRATES USING MEDIATING LAYERS**
HERSTELLUNG VON NANOSTRUKTUREN IN UND AUF ORGANISCHEN UND ANORGANISCHEN SUBSTRATEN MIT VERMITTLUNGSSCHICHTEN
FABRICATION DE NANOSTRUCTURES DANS ET SUR DES SUBSTRATS ORGANIQUES ET INORGANIQUES EN UTILISANT DES COUCHES DE MÉDIATION

(43) Date of publication of application: 31.01.2018
(73) Proprietor: Max-Planck-Gesellschaft zur Förderung der Wissenschaften e.V., 80539 München (DE)
(72) Inventor: DIRKS, Jan-Henning, 28201 Bremen (DE); CHEN, Wenwen, 70567 Stuttgart (DE); SPATZ, Joachim P., 70569 Stuttgart (DE); BRUNNER, Robert, 07743 Jena (DE); KRAUS, Matthias, 07745 Jena (DE)
(74) Representative: v. Bezold & Partner Patentanwälte - PartG mbB
(86) International application number: PCT/EP2015/000632
(87) International publication number: WO 2016/150453

(56) References cited:
- EP-A1- 3 130 946
- WO-A1-2014/196148
- US-A1- 2009 014 416
- US-A1- 2009 176 015

## Description

Several methods for generating nanostructures on various substrate surfaces are known in the art. Such nanostructures may be, e.g., used for immobilizing target entities such as bio-molecules or for providing antireflective coatings on the respective substrates.

One approach for generating nanostructures or nanopatterns on substrate surfaces is based on electron beam lithography. Typically, however, this methodology is rather slow and costly.

Another commonly used approach involves various etching techniques, including reactive ion etching (RIE), reactive ion beam etching (RIBE), plasma processes etc.

In particular, an especially advantageous method for providing antireflective structures, so called moth-eye structures (MOES), on quartz glass by means of a combination of block copolymer micellar nanolithography (BCML) and RIE has been developed (see, e.g. WO 2008/116616 A1).

However, these methods are often limited with respect to suitable substrate materials and applications. For example, a number of highly refractive substrates such as SF10 glass, CaF₂, Al₂O₃, are difficult or impossible to etch using said combination of BCML and RIE because the BCML mask and the substrates have similar etching rates and/or the etching parameters of the RIE treatment are unsuited for the desired substrate material.

In order to provide non-etchable primary substrates with such nanostructures, it is known to coat the primary substrate with an additional etchable material (such as silica) and to generate the desired nanostructures therein. Typically, however, the refractive index of these etchable layers differs from that of the refractive index of the primary substrate. This results in a considerable decrease of the antireflective properties of the nanostructured substrate. Further, the additional etchable layers tend to be mechanically instable and separate from the primary substrate under some conditions (mechanical or thermal stress).

US 2009/176015 A1 relates to an antireflection structure formation method and an antireflection structure.

US 2009/014416 A1 discloses a transparent textured substrate and methods for obtaining the same.

EP 3 130 946 A1 relates to an optical member and a method for manufacturing the same.

WO 2014/196148 A1 discloses an optical member provided with an antireflection film.

It was therefore an object of the present invention to provide nanostructures, in particular antireflective nanostructures, in and on a variety of organic and inorganic substrates, including substrate surfaces which were not amenable to conventional etching techniques, and the corresponding nanostructured substrates which overcome the above drawbacks of the prior art.

This object is achieved according to the invention with the provision of the method according to Claim 1 and the composite substrate according to Claim 10. Specific or preferred embodiments and aspects of the invention are the subject matter of the further claims.

### Description of the invention

The method according to the invention for creating nanostructures in and on organic or inorganic substrates according to Claim 1 comprises at least the following steps:
a) providing a primary substrate having a predetermined refractive index;
b) coating the primary substrate with a plurality of mediating layers each having a predetermined refractive index different from that of the primary substrate, wherein the sequence of the layers is arranged so that a predetermined gradient of the refractive index is generated between the primary substrate and the uppermost layer of the mediating layers;
c) optionally coating the uppermost layer of the mediating layers with an additional top layer;
d) depositing a nanostructured etching mask onto the uppermost layer of the composite substrate obtained after steps a)-b) or a)-c) ;
e) generating protruding structures, in particular conical or pillar structures, or recessed structures, in particular holes, in at least the uppermost layer of the composite substrate by means of reactive ion etching,
wherein the material of the plurality of mediating layers is selected from the group comprising SiOx (with 1<x<2) and SiOxNy (with y/y+x in the range from 0 to 0.5 and with N/(N+O) from 0% to 50%), the refractive index of the primary substrate is in the range from 1.46 to 2.01 and the refractive index of the uppermost layer of the composite substrate is in the range from 1.3 to 1.6.

In a specific embodiment of the method according to the present invention, the nanostructured etching mask comprises an ordered array of nanoparticles or statistically distributed nanoparticles in which the spatial frequencies of the statistical distribution shows only contributions which are larger than the inverse of the wavelength of light (typically from 30 nm to 300 nm).

In a preferred embodiment of the invention, an ordered array of nanoparticles is provided on the substrate surface by means of a micellar diblock copolymer nanolithography technology, as described e.g. in EP 1 027 157 B1 and DE 197 47 815 A1. In micellar nanolithography, a micellar solution of a block copolymer is deposited onto a substrate, e.g. by means of dip coating, and under suitable conditions forms an ordered film structure of chemically different polymer domains on the surface, which inter alia depends on the type, molecular weight and concentration of the block copolymer. The micelles in the solution can be loaded with inorganic salts which, following deposition with the polymer film, can be oxidized or reduced to inorganic nanoparticles. A further development of this technology, described in the patent application DE 10 2007 017 032 A1, enables to two-dimensionally set both the lateral separation length of the polymer domains mentioned and thus also of the resulting nanoparticles and the size of these nanoparticles by means of various measures so precisely that nanostructured surfaces with desired spacing and/or size gradients can be manufactured. Typically, nanoparticle arrangements manufactured with such a micellar nanolithography technology have a quasi-hexagonal pattern.

The BCML etching mask may be deposited on the primary substrate by any suitable method known in the art such as, e.g., dip coating or spin coating.

Principally, the material of the nanoparticles is not particularly limited and can comprise any material known in the prior art for such nanoparticles. Typically, this is a metal or metal oxide. A broad spectrum of suitable materials is mentioned in DE 10 2007 014 538 A1. Preferably, the material of the metal or the metal component of the nanoparticles is selected from the group made up of Au, Pt, Pd, Ag, In, Fe, Zr, Al, Co, Ni, Ga, Sn, Zn, Ti, Si and Ge, mixtures and composites thereof. Specific examples for a preferred metal oxide are titanium oxide, iron oxide and cobalt oxide. Preferred examples for a metal are gold, palladium and platinum and gold is particularly preferred.

The term "particle" as used here also comprises a "cluster", particularly as described and defined in DE 10 2007 014 538 A1 and DE 197 47 815 A1 and both terms can be used here interchangeably.

Advantageously, the material of the primary substrate is not especially limited and may be selected from a wide range of organic and inorganic substrates.

In one specific embodiment, the material of the primary substrate is selected from glasses, in particular comprising one of the following base systems of inorganic glasses with their main components: 1) B₂O₃ - La₂O₃ - MₘOₙ (m being an integer from 1 to 2 and n being an integer from 2 to 5; MₘOₙ preferably selected from ZrO₂, Ta₂O₅, Nb₂O₅, Gd₂O₃, Y₂O₃, TiO₂, WO₃); 2) (B₂O₃, SiO₂) - La₂O₃ - MO, MO being a metal oxide typically selected from MgO, CaO, SrO, BaO, ZnO; 3) SiO₂ - PbO - M₂O with (for example) M₂O selected from Li₂O, Na₂O, K₂O, Ca₂O; the PbO content in glasses of the system SiO₂ - PbO - M₂O can be replaced partially or completely by TiO₂; 4) SiO₂ - B₂O₃ - BaO; 5) (SiO₂, B₂O₃) - BaO - PbO; 6) SiO₂ - M₂O - TiO₂ (preferably the glass lattice/matrix comprises additional molecules, atoms, or ions of fluorine (e.g. F₂) and/or oxygen) with M₂O being a metal oxide typically selected from Li₂O, Na₂O, K₂O, Ca₂O; 7) P₂O₅ - Al₂O₃ - MO - B₂O₃ with (for example) MO selected from: MgO, CaO, SrO, BaO, ZnO; 8) SiO₂ - BaO - M₂O with (for example) M₂O selected from Li₂O, Na₂O, K₂O, Ca₂O.

In more specific embodiments, the material of the primary substrate comprises or consists of glasses and quartz glasses, in particular SF10, N-LASF 9 (Schott, refractive index 1.85), N-LASF 45 Schott, refractive index 1.80), N-SF6 (Schott, refractive index 1.81, N-SF57 (Schott, refractive index 1.85), SLAM66 (Ohara, refractive index 1.80), S-TIH14 (Ohara, refractive index 1.76), S-BAH28 (Ohara, refractive index 1.72), NBF1 (Hoya, refractive index 1.74), NBFD3 (Hoya, refractive index 1.81), or E-FD8 (Hoya, refractive index 1.69) glass, SiO₂, CaF₂, GaAs, Al₂O₃.

In preferred embodiments, the material of the primary substrate is selected from quartz glasses, in particular high quality quarz glasses, such as suprasil glass.

In another specific embodiment, the material of the primary substrate is selected from organic materials such as polymethylmethacrylate (PMMA), polycarbonate (PC), polycarbonate-comprising copolymers (e.g. PC-HT), styrene-methylmethacrylate-copolymer (SMMA), methacryl-acrylnitrile-butadien-styrene-copolymer (MABS), polystyrene (PS), styrene-acrylnitrile-copolymer (SAN), polymethacrylmethylimide (PMMI), cycloolefin-based polymers (COP), cycloolefin-based copolymers (COC), polyethersulfones (PES), polyetherimides (PEI), pol-methylenepentene (TPX), polyamide 12 (PA 12), allyldiglycol-carbonate.

The material of each of plurality of mediating layers is selected such that a desired gradient of the refractive index is generated between the primary substrate and the uppermost layer of the intermediate layers.

According to the invention, the material of the plurality of mediating layers is selected from the group comprising SiOx (with 1<x<2) and SiOxNy (with y/x+y in the range from 0 to 0.5 and with N/(N+O) from 0% to 50%).

The thickness of the plurality of mediating layer (s) is not especially limited and may be adjusted as appropriate for the respective substrate and coating materials and applications.

For optical applications, such as antireflective lenses, mediating layers having a total thickness in the range from 200 to 500 nm may be typically used.

The mediating layers typically are deposited by reactive pulse sputtering using a magnetron system from a silicon target. Argon can be used as inert gas and a mixture of oxygen and nitrogen as reactive gas. The mediating layers are formed by continuously adapting the ratio of the mixture of oxygen and nitrogen. The deposition of the layers typically starts from the refractive index of the substrate glass and is decreased down to that of the top layer, typically SiO₂.

Typically, the nanostructures created by one or more etching treatments are conical or pillar-shaped structures. The height of the structures typically lies in a range of 50 nm to 400 nm, preferably of 150 nm to 300, and typically they have a diameter in the range of 5 nm to 50 nm, preferably of 10 nm to 30 nm, (measured in half height of the structures).

The refractive index of the primary substrate is in the range from 1.46 to 2.01, typically in the range from 1.6 to 1.9, and the refractive index of the uppermost layer of the composite substrate obtained after steps a)-b) or a)-c) above is in the range from 1.3 to 1.6., typically in the range of SiO₂.

The material of the optional additional top layer may be identical with or different from the material of the mediating layer(s). In the first case, the material of the additional top layer may be selected from the group comprising quartz glass, such as SiO₂ and SiOxNy (with x and y as defined above), with N/(N+O) from 0% to 50%.

In any case, the additional top layer does not contribute to the gradient of the refractive index generated by the layers below, thus its refractive index will ideally be identical with the uppermost layer of the intermediate layers.

The thickness of the top layer may in the range from 50 to 1200 nm.

Suitable methods for plasma etching or reactive ion etching are principally known in the art (see, e.g. DE 10 2007 014 538 A1 and Lohmüller et al. (NANO LETTERS 2008, Vol. 8, No. 5, 1429-1433).

The etching step e) can comprise one or several treatments with the same etching agent and/or with different etching agents. The etchant can basically be any etchant known in the prior art and suitable for the respective substrate surface. Preferably, the etchant is selected from the group of chlorine gases, e.g. Cl₂, BCl₃ and other gaseous chlorine compounds, fluorinated hydrocarbons, e.g. CHF₃, CH₂F₂, CH₃F, fluorocarbons, e.g. CF₄, C₂F₈, oxygen, argon, SF₆ and mixtures thereof.

Preferably, the etching comprises at least one treatment with a mixture of Ar/SF₆/O₂ or Ar/SF₆ as etchant and at least one treatment with a mixture of Ar/CHF₃ as etchant.

For example, a combination of a first etching step with a mixture of Ar/SF₆ as etchant and a second etching step with a mixture of Ar/SF₆/O₂ may be used to produce pillar-shaped nanostructures from a SiOx substrate. A combination of a first etching step with a mixture of Ar/SF₆/O₂ and a second etching step with a mixture of Ar/CHF₃ may be used to produce conical nanostructures from a SiOx substrate.

Typically, each etching step is carried out for a period in the range of 5 s or 10 s to 10 min, preferably in the range from 10 s to 60 s.

The duration of the entire etching treatment typically lies in the range of 10 s to 60 minutes, preferably 1 to 15 minutes.

Typically, the obtained nanostructures have a diameter in the range of 10-100 nm, preferably 10-30 nm, and a height of 10-800 nm, preferably 250-500 nm. In the case of conical structures, the diameter data refer to the thickness at half height. The average spacings of the nanostructures are preferably in a range from 15 to 250 nm.

For some applications it is preferred that the nanoparticles used as an etching mask have a predetermined two-dimensional geometric arrangement on the substrate surface. Such arrangement has predetermined minimum or average particle spacings as a characteristic, wherein these predetermined particle spacings can be the same in all regions of the substrate surface or various regions can have different predetermined particle spacings. A geometric arrangement of this type can fundamentally be realized with any suitable method of the prior art, micellar nanolithography in particular, as explained in more detail above.

Some embodiments of the method according to the present invention involve at least one further processing step of a mechanical treatment, such as sonication, of the protruding structures generated in the course of the etching step.

In a specific embodiment of the present invention, the structures generated in the top layer and/or the mediating layer(s) of the composite substrate are used as an etching mask and protruding structures corresponding to the protruding structures of the layer (s) above are generated in the primary substrate and the layer(s) above the primary substrate are removed in part or completely.

This further etching treatment may be accomplished by means of reactive ion beam etching (RIBE), chemically assisted ion beam etching (CAIBE), reactive ion etching (RIE) or inductive coupled plasma (RIE-ICP) as appropriate for the respective substrate layer.

Using the above multi-step-etching process enables to achieve nanostructures on or in the primary substrate which were not obtainable by a direct etching treatment of the primary substrate.

A nanostructured primary substrate which is free from any coating layers (mediating layers and optionally a top layer) is mechanically more stable, since no coating layers are potentially detachable under conditions of mechanical or thermal stress. Also, if the coating layers are completely removed in the final etching step, it is possible to use toxic or non-biocompatible intermediate layers and still obtain a biocompatible final product. This allows more flexibility in conducting the method of the invention.

In a preferred embodiment of the invention, the composite substrate obtained by the method as outlined above is an optical element and the protruding structures generated form an anti-reflective surface structure on the optical element.

A further aspect of the present invention relates to the nanostructured composite substrate obtainable by the method as outlined above.

Typically, the composite substrate with a nanostructured surface according to the present invention comprises a primary substrate having a defined refractive index, preferably in the range from 1.3 to 2.1; a plurality of mediating layers having a predetermined refractive index different from that of the primary substrate wherein the sequence of the layers is arranged so that a defined gradient of the refractive index is provided between the primary substrate and the uppermost layer of the mediating layers; optionally an additional top layer; and nanostructures, in particular conical or pillar structures, on the surface of the composite substrate, which structures are composed of the material of the additional top layer of the composite substrate (optionally capped with nanoparticles) and the material of the plurality of mediating layers, wherein the material of the plurality of mediating layers is selected from the group comprising SiOx (with 1<x<2) and SiOxNy (with y/x+y in the range from 0 to 0.5 and with N/(N+O) from 0% to 50%).

In a more specific embodiment of said composite substrate, the protruding structures further comprise of material of the primary substrate.

Preferably, the nanostructured composite substrate or primary substrate is an optical element and the protruding structures form an anti-reflective surface structure on the optical element.

In a more specific embodiment of said composite substrate or optical element, the protruding structures have a predetermined two-dimensional geometric arrangement, in particular a hexagonal arrangement, or are statistically distributed such that the spatial frequencies of the statistical distribution shows only contributions which are larger than the inverse of the wavelength of light (typically in a range from 30 nm to 300 nm).

In one specific embodiment, the material of the primary substrate is selected from glasses, in particular comprising one of the following base systems of inorganic glasses with their main components: 1) B₂O₃ - La₂O₃ - MₘOₙ (m being an integer from 1 to 2 and n being an integer from 2 to 5; MₘOₙ preferably selected from ZrO₂, Ta₂O₅, Nb₂O₅, Gd₂O₃, Y₂O₃, TiO₂, WO₃); 2) (B₂O₃, SiO₂) - La₂O₃ - MO, MO being a metal oxide typically selected from MgO, CaO, SrO, BaO, ZnO; 3) SiO₂ - PbO - M₂O with (for example) M₂O selected from Li₂O, Na₃O, K₂O, Ca₃O; the PbO content in glasses of the system SiO₂ - PbO - M₂O can be replaced partially or completely by TiO₂; 4) SiO₂ - B₂O₃ - BaO; 5) (SiO₂, B₂O₃) - BaO - PbO; 6) SiO₂ - M₂O - TiO₂ (preferably the glass lattice/matrix comprises or is doped with additional molecules, atoms, or ions of fluorine and/or oxygen) with M₂O being a metal oxide typically selected from Li₂O, Na₂O, K₂O, Ca₂O; 7) P₂O₅ - Al₂O₃ - MO - B₂O₃ with (for example) MO selected from: MgO, CaO, SrO, BaO, ZnO; 8) SiO₂ - BaO - M₂O with (for example) M₂O selected from Li₂O, Na₂O, K₂O, Ca₂O.

In more specific embodiments, the material of the primary substrate comprises or consists of glasses and quartz glasses, in particular SF10, N-LASF 9 (Schott, refractive index 1.85), N-LASF 45 Schott, refractive index 1.80), N-SF6 (Schott, refractive index 1.81, N-SF57 (Schott, refractive index 1.85), SLAM66 (Ohara, refractive index 1.80), S-TIH14 (Ohara, refractive index 1.76), S-BAH28 (Ohara, refractive index 1.72), NBF1 (Hoya, refractive index 1.74), NBFD3 (Hoya, refractive index 1.81), or E-FD8 (Hoya, refractive index 1.69) glass, SiO₂, CaF₂, GaAs, Al₂O₃.

In preferred embodiments, the material of the primary substrate is selected from quartz glasses, in particular high quality quarz glasses, such as suprasil glass.

In another specific embodiment, the material of the primary substrate is selected from organic materials such as polymethylmethacrylate (PMMA), polycarbonate (PC), polycarbonate-comprising copolymers (e.g. PC-HT), styrene-methylmethacrylate-copolymer (SMMA), methacryl-acrylnitrile-butadien-styrene-copolymer (MABS), polystyrene (PS), styrene-acrylnitrile-copolymer (SAN), polymethacrylmethylimide (PMMI), cycloolefin-based polymers (COP), cycloolefin-based copolymers (COC), polyethersulfones (PES), polyetherimides (PEI), pol-methylenepentene (TPX), polyamide 12 (PA 12), allyldiglycol-carbonate.

The material of the plurality of mediating layers of the composite material is selected from the group comprising SiOx (with 1<x<2) and SiOxNy (with y/x+y in the range from 0 to 0.5 and N/(N+O) from 0% to 50%).

Also, the material of the additional top layer, if any, is preferably selected from the group comprising quartz glass, such as SiO₂ and SiOxNy, SiOx (with 1<x<2) and SiOxNy, with x and y as defined above and N/(N+O) from 0% to 50%.

The products of the method according to the invention offer a wide range of application options in the fields of semiconductor technology, optics, sensor technology and photovoltaics.

A few non-limiting examples for this are the use in optical devices, particularly optical elements such as lenses, diffraction gratings and other refracting or diffractive structures, sensors, particularly CCD sensors and solar cells.

A particularly preferred application relates to the use in optical elements, particularly for minimizing reflection.

### Brief description of the figures

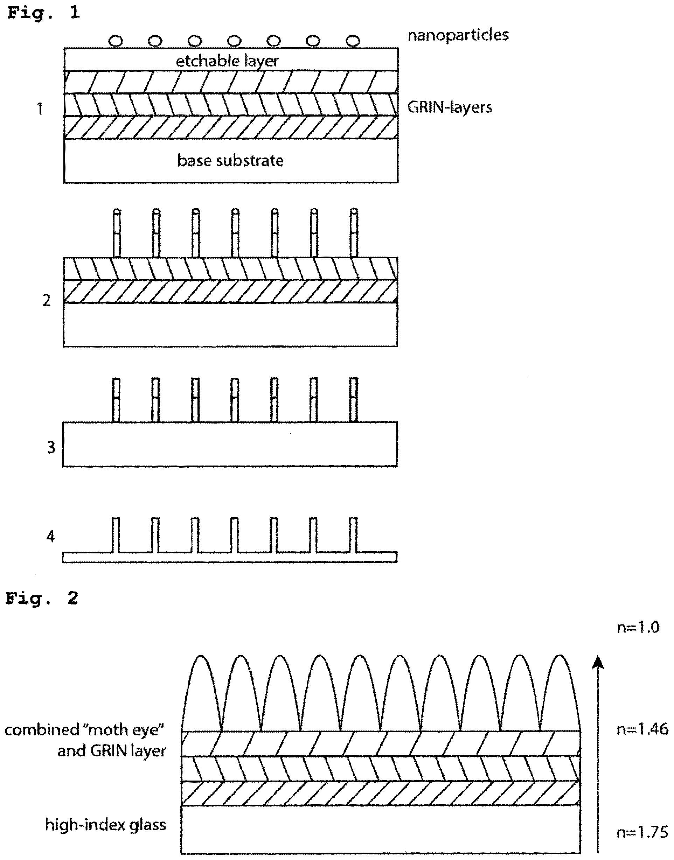

Fig. 1 schematically shows the main steps of the method according to the invention for preparing a nanostructured composite substrate or primary substrate.
Fig. 2 schematically shows the gradient of the refractive index formed by the primary substrate and the overlaid mediating layers.
Fig. 3 shows the data of transmission measurements performed on a plain SF10 substrate, a GRIN-coated SF10 substrate and a SF10 substrate coated with GRIN and an additional layer of MOES. The optical characterisation of plain, GRIN and MOES+GRIN substrates shows that the transmission of MOES+GRIN structured substrates is superior compared to the transmission of GRIN-structured surfaces alone.

The following examples are used for more in depth explanation of the present invention, without limiting the same thereto, however. It will be evident for the person skilled in the art that variations of these conditions in dependence of the specific materials used may be required and can be determined without difficulty by means of routine experiments.

### EXAMPLE 1

### Creation of nanostructures on a composite substrate

### 1. Providing a composite substrate

A primary substrate of SF10 glass is coated with several intermediate layers of amorphous SiₓO_{y}N_{z} forming a gradient of refractive indices (GRIN) . The indices x, y and z of each intermediate layer are selected to provide a desired refractive index difference to the underlying layer. The GRIN layers are deposited by reactive pulse sputtering using a magnetron system from a silicon target. Argon was used as inert gas and a mixture of oxygen and nitrogen as reactive gas.

The layered structure of the GRIN-layer is formed by continuously adapting the ratio of the mixture of oxygen and nitrogen. The deposition of the GRIN profile is starting from the refractive index of the base substrate (SF10) and is decreased down to that of the covering SiO₂ layer, forming the composite substrate consisting of SF10 (base), GRIN layer and a top SiO₂ layer.

### 2. Providing an array of nanoparticles on the substrate surface

The surface of the uppermost layer of the composite substrate was coated with gold nanoparticles in a defined arrangement by means of micellar nanolithography. In this step, one of the protocols described in EP 1 027 157 B1, DE 197 47 815 A1 or DE 10 2007 017 032 A1 can be followed. The method involves the deposition of a micellar solution of a block copolymer (e.g. polystyrene(n)-b-poly(2-vinylpyridine(m)) in toluene) onto the substrate, e.g. by means of dip or spin coating, as a result of which an ordered film structure of polymer domains is formed on the surface. The micelles in the solution are loaded with a gold salt, preferably HAuCl₄, which, following deposition with the polymer film, can be reduced to the gold nanoparticles.

The reduction can take place chemically, e.g. with hydrazine, or by means of energy-rich radiation, such as electron radiation or light. Optionally, after or at the same time as the reduction, the polymer film can be removed (e.g. by means of plasma etching with Ar-, H- or O-ions). Thereafter, the substrate surface is covered with an arrangement of gold nanoparticles.

### 3. First Etching

Subsequently, the etching of the substrate surface covered with gold nanoparticles took place in a desired depth. A "reactive ion etcher" from Oxford Plasma, device: PlasmaLab 80 plus was used to this end. Other devices known in the prior art are likewise fundamentally suitable, however. The etching consisted of two treatment steps with various etchants which were carried out several times one after the other.

The following protocol was used to create conical nanostructures:

### Step 1:

A mixture of Ar/SF₆/O₂ in the ratio 10:40:8 (sccm) was used as etchant (process gas).
Pressure: 50 mTorr
RF power: 120 W
ICP power: 0 W
Time: 60 s

### Step 2:

Etchant: Ar/CHF₃:40:40
Pressure: 50 mTorr
RF power: 120 W
ICP power: 20 W
Time: 20 s

These 2 steps were carried out alternately 8 times.

Alternatively, the following protocol was used to create pillar-shaped nanostructures:

### Step 1:

A mixture of Ar/SF₆ in the ratio 40:40 (sccm) was used as etchant (process gas).
Pressure: 50 mTorr
RF power: 120 W
ICP power: 0 W
Time: 60 s

### Step 2:

Etchant: Ar/CHF₃:40:40
Pressure: 50 mTorr
RF power: 120 W
ICP power: 20 W
Time: 20 s

These 2 steps were carried out alternately 8 times.

The total duration of the etching treatment varied depending on the desired depth of the etching within about 1-15 minutes. As a result, column-like or conical nanostructures were obtained, which still can show gold nanoparticles on their upper side.

### 4. Second Etching

The nanostructures created in the mediating layers according to step 3 above can further be used as an etching mask for transferring said nanostructures into the primary substrate layer by means of reactive ion beam etching (RIBE). Compared to the previous RIE process, the RIBE process is less selective and can etch substrates, which cannot be etched using RIE.

Reactive ion beam etching (RISE) uses an energetic, broad beam collimated and highly directional ion source to physically mill material from a substrate mounted on a rotating fixture with adjustable tilt angle. In contrast to ion beaming (IBE), in the RIBE process reactive ions are incorporated in whole or in part in the etching ion beam.

The ion sources used are "gridded" ion sources, e.g. of the Kaufman type or microwave electron cyclotron resonance (ECR). The etching process involves the control of the ion incident angle and a separate control of the ion flux and ion energy. Typical reactive and inert gases used for RIBE are Ar, N₂, O₂, CHF₃ CF₄ and SF₆.

The RIBE process directly transferred the nanostructure of the mediating layer into the base substrate.

### EXAMPLE 2

### Characterisation of nanostructured composite or primary substrates

To illustrate the superior optical properties of the MOES+GRIN substrates, a plain SF10 surface, a GRIN coated SF10 surface and a single-sided MOES+GRIN coated surface were optically characterised using a spectrometer.

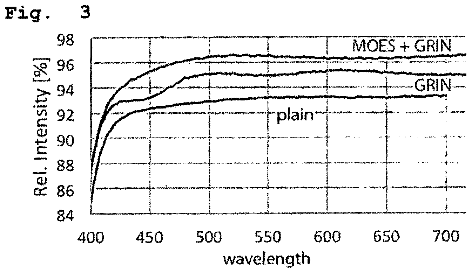

Compared to the plain SF10 substrate, the MOES+GRIN substrate shows a notably improved transmission, which covers a wide rage of wavelengths, as typical for MOES structures (see Fig. 3) .

## Claims

1. A method for producing nanostructures in and on organic or inorganic substrates comprising at least the following steps:
a) providing a primary substrate having a predetermined refractive index;
b) coating the primary substrate with a plurality of mediating layers each having a predetermined refractive index different from that of the primary substrate, wherein the sequence of the layers is arranged so that a predetermined gradient of the refractive index is generated between the primary substrate and the uppermost layer of the mediating layers;
c) optionally coating the uppermost layer of the mediating layers with an additional top layer;
d) depositing a nanostructured etching mask onto the uppermost layer of the composite substrate obtained after steps a)-b) or a)-c) ;
e) generating protruding structures, in particular conical or pillar structures, or recessed structures, in particular holes, in at least the uppermost layer of the composite substrate by means of reactive ion etching,
wherein the material of the plurality of mediating layers is selected from the group comprising SiOx (with 1<x<2) and SiOxNy (with y/y+x in the range from 0 to 0.5 and with N/(N+O) from 0% to 50%), the refractive index of the primary substrate is in the range from 1.46 to 2.01 and the refractive index of the uppermost layer of the composite substrate is in the range from 1.3 to 1.6.

2. The method according to claim 1, wherein the nanostructured etching mask comprises an ordered array of nanoparticles.

3. The method according to claim 2, wherein the ordered array of nanoparticles forming the etching mask is provided by means of micellar diblock or multiblock copolymer nanolithography.

4. The method according to any one of claims 1-3, wherein
the material of the primary substrate is selected from quartz glasses and glasses, in particular comprising one of the following base systems of inorganic glasses with their main components: 1) B₂O₃ - La₂O₃ - MₘOₙ (m being an integer from 1 to 2 and n being an integer from 2 to 5; MₘOₙ preferably selected from ZrO₂, Ta₂O₅, Nb₂O₅, Gd₂O₃, Y₂O₃, TiO₂, WO₃); 2) (B₂O₃, SiO₂) - La₂O₃ - MO, MO being a metal oxide typically selected from MgO, CaO, SrO, BaO, ZnO; 3) SiO₂ - PbO - M₂O with M₂O preferably selected from Li₂O, Na₂O, K₂O, Ca₂O; the PbO content in glasses of the system SiO₂- PbO - M₂O being partially or completely replaceable by TiO₂; 4) SiO₂ - B₂O₃ - BaO; 5) (SiO₂, B₂O₃) - BaO - PbO; 6) SiO₂ - M₂O - TiO₂ (preferably comprising additional molecules, atoms, or ions of fluorine and/or oxygen) with M₂O being a metal oxide typically selected from Li₂O, Na₂O, K₂O, Ca₂O; 7) P₂O₅ - Al₂O₃ - MO - B₂O₃ with MO preferably selected from: MgO, CaO, SrO, BaO, ZnO; 8) SiO₂ - BaO - M₂O with M₂O preferably selected from Li₂O, Na₂O, K₂O, Ca₂O,
and/or
wherein the material of the additional top layer is selected from the group comprising quartz glass, such as SiO₂ and SiOxNy, with x and y as defined in claim 1 and N/(N+O) from 0% to 50%.

5. The method according to any one of claims 1-4, wherein the etching comprises at least one treatment with an etchant which is selected from the group of chlorine, gaseous chlorine compounds, fluorinated hydrocarbons, fluorocarbons, oxygen, argon, SF₆ and mixtures thereof, and wherein each etching treatment preferably is carried out for a period in the range of 10 s to 10 min.

6. The method according to claim 5, wherein the etching comprises at least one treatment with a mixture of Ar/SF₆/O₂ or Ar/SF6 as etchant and at least one treatment with a mixture of Ar/CHF₃ as etchant.

7. The method according to any one of claims 1-6 which further comprises a mechanical treatment, such as sonication, of the protruding structures generated.

8. The method according to any one of claims 1-7 which comprises a further etching treatment by means of reactive ion beam etching (RIBE), chemically assisted ion beam etching (CAIBE), reactive ion etching (RIE) or inductive coupled plasma
(RIE-ICP), wherein the structures generated in the top layer and/or the mediating layer(s) of the composite substrate are used as an etching mask and protruding structures corresponding to the protruding structures of the layer(s) above are generated in the primary substrate and the layer(s) above the primary substrate are removed in part or completely.

9. The method according to any one of claims 1-8, wherein the composite substrate is an optical element and the structures generated form an anti-reflective surface structure on the optical element.

10. A composite substrate with a nanostructured surface comprising
- a primary substrate having a defined refractive index, preferably in the range from 1.3 to 2.1;
- a plurality of mediating layers having a predetermined refractive index different from that of the primary substrate wherein the sequence of the layers is arranged so that a defined gradient of the refractive index is provided between the primary substrate and the uppermost layer of the mediating layers;
- optionally an additional top layer;
- nanostructures, in particular conical or pillar structures, on the surface of the composite substrate, which structures are composed of the material of the additional top layer of the composite substrate and the material of the mediating layers,
wherein the material of the plurality of mediating layers is selected from the group comprising SiOx (with 1<x<2) and SiOxNy (with y/y+x in the range from 0 to 0.5 and N/(N+O) from 0% to 50%.

11. The composite substrate according to claim 10, wherein the protruding structures further comprise material of the primary substrate.

12. The composite substrate according to claim 10 or 11, wherein the composite substrate is an optical element and the protruding structures generated form an anti-reflective surface structure on the optical element.

13. The composite substrate according to claim 11 or 12, wherein the protruding structures have a predetermined two-dimensional geometric arrangement, in particular a hexagonal arrangement.

14. The composite substrate according to any one of claims 10-13, wherein the material of the primary substrate is selected from quartz glasses and glasses, in particular comprising one of the following base systems of inorganic glasses with their main components: 1) B₂O₃ - La₂O₃ - MₘOₙ (m being an integer from 1 to 2 and n being an integer from 2 to 5; MₘOₙ preferably selected from ZrO₂, Ta₂O₅, Nb₂O₅, Gd₂O₃, Y₂O₃, TiO₂, WO₃); 2) (B₂O₃, SiO₂) - La₂O₃ - MO, MO being a metal oxide typically selected from MgO, CaO, SrO, BaO, ZnO; 3) SiO₂ - PbO - M₂O with M₂O preferably selected from Li₂O, Na₂O, K₂O, Ca₂O; the PbO content in glasses of the system SiO₂- PbO - M₂O being partially or completely replaceable by TiO₂; 4) SiO₂ - B₂O₃ - BaO; 5) (SiO₂, B₂O₃) - BaO - PbO; 6) SiO₂ - M₂O - TiO₂ (preferably comprising additional molecules, atoms, or ions of fluorine and/or oxygen) with M₂O being a metal oxide typically selected from Li₂O, Na₂O, K₂O, Ca₂O; 7) P₂O₅ - Al₂O₃ - MO - B₂O₃ with MO preferably selected from: MgO, CaO, SrO, BaO, ZnO; 8) SiO₂ - BaO - M₂O with M₂O preferably selected from Li₂O, Na₂O, K₂O, Ca₂O,
and/or
wherein the material of the top layer is selected from the group comprising quartz glass, such as SiO₂ and SiOxNy, with x and y as defined in claim 10 above and N/(N+O) from 0% to 50%.

15. A use of the composite substrate according to claim 10 or the optical element according to claim 12 in the fields of semiconductor technology, optics, sensor technology and photovoltaics.

16. The use according to claim 15 in optical devices, sensors, particularly CCD sensors and solar cells.

## Patentansprüche

1. Verfahren zur Herstellung von Nanostrukturen in und auf organischen oder anorganischen Substraten, umfassend mindestens die folgenden Schritte:
a) Bereitstellen eines Primärsubstrats mit einem vorgegebenen Brechungsindex;
b) Beschichten des Primärsubstrats mit einer Mehrzahl von vermittelnden Schichten, die jeweils einen vorgegebenen Brechungsindex aufweisen, der von demjenigen des Primärsubstrats verschieden ist, wobei die Abfolge der Schichten so angeordnet ist, dass ein vorgegebener Gradient des Brechungsindex zwischen dem Primärsubstrat und der obersten Schicht der vermittelnden Schichten ausgebildet ist;
c) gegebenenfalls Beschichten der obersten Schicht der vermittelnden Schichten mit einer zusätzlichen obersten Schicht;
d) Abscheiden einer nanostrukturierten Ätzmaske auf der obersten Schicht des Verbundsubstrats, das nach den Schritten a)-b) oder a)-c) erhalten worden ist;
e) Erzeugen von vorragenden Strukturen, insbesondere konischen Strukturen oder Säulenstrukturen, oder vertieften Strukturen, insbesondere Löchern, in mindestens der obersten Schicht des Verbundsubstrats mittels reaktivem lonenätzen,
wobei das Material der Mehrzahl von vermittelnden Schichten aus der Gruppe, umfassend SiOx (mit 1 < x < 2) und SiOxNy (mit y/y + x im Bereich von 0 bis 0,5 und mit N/(N + O) von 0 % bis 50 %), ausgewählt ist, wobei der Brechungsindex des Primärsubstrats im Bereich von 1,46 bis 2,01 liegt und der Brechungsindex der obersten Schicht des Verbundsubstrats im Bereich von 1,3 bis 1,6 liegt.

2. Verfahren nach Anspruch 1, wobei die nanostrukturierte Ätzmaske eine geordnete Gruppierung von Nanoteilchen umfasst.

3. Verfahren nach Anspruch 2, wobei die geordnete Gruppierung von Nanoteilchen, welche die Ätzmaske bildet, durch eine mizellare Diblock- oder Multiblockcopolymer-Nanolithographie bereitgestellt wird.

4. Verfahren nach einem der Ansprüche 1 bis 3, wobei
das Material des Primärsubstrats aus Quarzgläsern und Gläsern ausgewählt ist, die insbesondere eines der folgenden Basissysteme von anorganischen Gläsern mit deren Hauptkomponenten: 1) B₂O₃ - La₂O₃ - MₘOₙ (wobei m eine ganze Zahl von 1 bis 2 ist und n eine ganze Zahl von 2 bis 5 ist; wobei MₘOₙ vorzugsweise aus ZrO₂, Ta₂O₅, Nb₂O₅, Gd₂O₃, Y₂O₃, TiO₂, WO₃ ausgewählt ist); 2) (B₂O₃, SiO₂) - La₂O₃ - MO, wobei MO ein Metalloxid ist, das typischerweise aus MgO, CaO, SrO, BaO, ZnO ausgewählt ist; 3) SiO₂- PbO - M₂O, wobei M₂O vorzugsweise aus Li₂O, Na₂O, K₂O, Ca₂O ausgewählt ist; wobei der PbO-Gehalt in Gläsern des Systems SiO₂ - PbO - M₂O teilweise oder vollständig durch TiO₂ ersetzbar ist; 4) SiO₂ - B₂O₃ - BaO; 5) (SiO₂, B₂O₃)- BaO - PbO; 6) SiO₂ - M₂O - TiO₂ (das vorzugsweise zusätzliche Moleküle, Atome oder Ionen von Fluor und/oder Sauerstoff umfasst), wobei M₂O ein Metalloxid ist, das typischerweise aus Li₂O, Na₂O, K₂O, Ca₂O ausgewählt ist; 7) P₂O₅ - Al₂O₃ - MO - B₂O₃, wobei MO vorzugsweise aus: MgO, CaO, SrO, BaO, ZnO ausgewählt ist; 8) SiO₂ - BaO - M₂O, wobei M₂O vorzugsweise aus Li₂O, Na₂O, K₂O, Ca₂O ausgewählt ist, umfassen,
und/oder
wobei das Material der zusätzlichen obersten Schicht aus der Gruppe, umfassend Quarzglas, wie z.B. SiO₂ und SiOxNy, wobei x und y wie im Anspruch 1 festgelegt sind und N/(N + O) von 0 % bis 50 % beträgt, ausgewählt ist.

5. Verfahren nach einem der Ansprüche 1 bis 4, wobei das Ätzen mindestens eine Behandlung mit einem Ätzmittel umfasst, das aus der Gruppe von Chlor, gasförmigen Chlorverbindungen, fluorierten Kohlenwasserstoffen, Fluorkohlenstoffen, Sauerstoff, Argon, SF₆ und Gemischen davon ausgewählt ist, und wobei jede Ätzbehandlung vorzugsweise für einen Zeitraum im Bereich von 10 s bis 10 min durchgeführt wird.

6. Verfahren nach Anspruch 5, wobei das Ätzen mindestens eine Behandlung mit einem Gemisch aus Ar/SF₆/O₂ oder Ar/SF₆ als Ätzmittel und mindestens eine Behandlung mit einem Gemisch aus Ar/CHF₃ als Ätzmittel umfasst.

7. Verfahren nach einem der Ansprüche 1 bis 6, das ferner eine mechanische Behandlung, wie z.B. eine Schallbehandlung, der erzeugten vorragenden Strukturen umfasst.

8. Verfahren nach einem der Ansprüche 1 bis 7, das eine weitere Ätzbehandlung mittels reaktivem Ionenstrahlätzen (RIBE), chemisch unterstütztem Ionenstrahlätzen (CAIBE), reaktivem lonenätzen (RIE) oder induktiv gekoppeltem Plasma (RIE-ICP) umfasst, wobei die Strukturen, die in der obersten Schicht und/oder der/den vermittelnden Schicht(en) des Verbundsubstrats erzeugt worden sind, als Ätzmaske verwendet werden und vorragende Strukturen, die den vorstehenden vorragenden Strukturen der Schicht(en) in dem Primärsubstrat und der/den Schicht(en) oberhalb des Primärsubstrats entsprechen, teilweise oder vollständig entfernt werden.

9. Verfahren nach einem der Ansprüche 1 bis 8, wobei das Verbundsubstrat ein optisches Element ist und die erzeugten Strukturen eine Reflexionsschutz-Oberflächenstruktur auf dem optischen Element bilden.

10. Verbundsubstrat mit einer nanostrukturierten Oberfläche, umfassend
- ein Primärsubstrat mit einem festgelegten Brechungsindex, vorzugsweise im Bereich von 1,3 bis 2,1;
- eine Mehrzahl von vermittelnden Schichten mit einem vorgegebenen Brechungsindex, der von demjenigen des Primärsubstrats verschieden ist, wobei die Abfolge der Schichten so angeordnet ist, dass ein festgelegter Gradient des Brechungsindex zwischen dem Primärsubstrat und der obersten Schicht der vermittelnden Schichten ausgebildet ist;
- gegebenenfalls eine zusätzliche oberste Schicht;
- Nanostrukturen, insbesondere konische Strukturen oder Säulenstrukturen, auf der Oberfläche des Verbundsubstrats, wobei die Strukturen aus dem Material der zusätzlichen obersten Schicht des Verbundsubstrats und dem Material der vermittelnden Schichten zusammengesetzt sind,
wobei das Material der Mehrzahl von vermittelnden Schichten aus der Gruppe, umfassend SiOx (mit 1 < x < 2) und SiOxNy (mit y/y + x im Bereich von 0 bis 0,5 und mit N/(N + O) von 0 % bis 50 %), ausgewählt ist.

11. Verbundsubstrat nach Anspruch 10, wobei die vorragenden Strukturen ferner ein Material des Primärsubstrats umfassen.

12. Verbundsubstrat nach Anspruch 10 oder 11, wobei das Verbundsubstrat ein optisches Element ist und die erzeugten vorragenden Strukturen eine Reflexionsschutz-Oberflächenstruktur auf dem optischen Element bilden.

13. Verbundsubstrat nach Anspruch 11 oder 12, wobei die vorragenden Strukturen eine vorgegebene zweidimensionale geometrische Anordnung, insbesondere eine hexagonale Anordnung, bilden.

14. Verbundsubstrat nach einem der Ansprüche 10 bis 13, wobei das Material des Primärsubstrats aus Quarzgläsern und Gläsern ausgewählt ist, die insbesondere eines der folgenden Basissysteme von anorganischen Gläsern mit deren Hauptkomponenten: 1) B₂O₃ - La₂O₃ - MₘOₙ (wobei m eine ganze Zahl von 1 bis 2 ist und n eine ganze Zahl von 2 bis 5 ist; wobei MₘOₙ vorzugsweise aus ZrO₂, Ta₂O₅, Nb₂O₅, Gd₂O₃, Y₂O₃, TiO₂, WO₃ ausgewählt ist); 2) (B₂O₃, SiO₂) - La₂O₃ - MO, wobei MO ein Metalloxid ist, das typischerweise aus MgO, CaO, SrO, BaO, ZnO ausgewählt ist; 3) SiO₂- PbO - M₂O, wobei M₂O vorzugsweise aus Li₂O, Na₂O, K₂O, Ca₂O ausgewählt ist; wobei der PbO-Gehalt in Gläsern des Systems SiO₂ - PbO - M₂O teilweise oder vollständig durch TiO₂ ersetzbar ist; 4) SiO₂ - B₂O₃ - BaO; 5) (SiO₂, B₂O₃)- BaO - PbO; 6) SiO₂ - M₂O - TiO₂ (das vorzugsweise zusätzliche Moleküle, Atome oder Ionen von Fluor und/oder Sauerstoff umfasst), wobei M₂O ein Metalloxid ist, das typischerweise aus Li₂O, Na₂O, K₂O, Ca₂O ausgewählt ist; 7) P₂O₅ - Al₂O₃ - MO - B₂O₃, wobei MO vorzugsweise aus: MgO, CaO, SrO, BaO, ZnO ausgewählt ist; 8) SiO₂ - BaO - M₂O, wobei M₂O vorzugsweise aus Li₂O, Na₂O, K₂O, Ca₂O ausgewählt ist, umfassen,
und/oder
wobei das Material der obersten Schicht aus der Gruppe, umfassend Quarzglas, wie z.B. SiO₂ und SiOxNy, wobei x und y wie vorstehend im Anspruch 10 festgelegt sind und N/(N + O) von 0 % bis 50 % beträgt, ausgewählt ist.

15. Verwendung des Verbundsubstrats nach Anspruch 10 oder des optischen Elements nach Anspruch 12 in den Bereichen der Halbleitertechnologie, der Optik, der Sensortechnologie und der Photovoltaik.

16. Verwendung nach Anspruch 15 in optischen Vorrichtungen, Sensoren, insbesondere CCD-Sensoren, und Solarzellen.

## Revendications

1. Procédé de production de nanostructures dans et sur des substrats organiques ou inorganiques comprenant au moins les étapes suivantes :
a) la fourniture d'un substrat primaire ayant un indice de réfraction prédéterminé ;
b) le revêtement du substrat primaire avec une pluralité de couches de médiation ayant chacune un indice de réfraction prédéterminé différent de celui du substrat primaire, dans lequel la séquence des couches est agencée de telle sorte qu'un gradient prédéterminé de l'indice de réfraction est généré entre le substrat primaire et la couche la plus haute desdites couches de médiation ;
c) facultativement le revêtement de la couche la plus haute desdites couches de médiation avec une couche supérieure supplémentaire ;
d) le dépôt d'un masque de gravure nanostructuré sur la couche la plus haute du substrat composite obtenu après les étapes a) et b) ou a) à c) ;
e) la génération de structures en saillie, en particulier de structures coniques ou en forme de pilier, ou de structures en renfoncement, en particulier de trous, dans au moins la couche la plus haute du substrat composite par gravure par ions réactifs,
dans lequel le matériau de la pluralité de couches de médiation est sélectionné dans le groupe comprenant SiOx (avec 1 < x < 2) et SiOxNy (avec y/y+x dans la plage de 0 à 0,5 et avec N/(N+O) de 0 % à 50 %), l'indice de réfraction du substrat primaire est dans la plage de 1,46 à 2,01 et l'indice de réfraction de la couche la plus haute du substrat composite est dans la plage de 1,3 à 1,6.

2. Procédé selon la revendication 1, dans lequel le masque de gravure nanostructuré comprend un réseau ordonné de nanoparticules.

3. Procédé selon la revendication 2, dans lequel le réseau ordonné de nanoparticules formant le masque de gravure est fourni au moyen d'une nanolithographie de copolymère diséquencé ou multiséquencé micellaire.

4. Procédé selon l'une quelconque des revendications 1 à 3, dans lequel le matériau du substrat primaire est sélectionné parmi les verres de quartz et les verres, comprenant en particulier l'un des systèmes de base de verres inorganiques suivants avec leurs composants principaux : 1) B₂O₃ - La₂O₃ - MₘOₙ (m étant un nombre entier de 1 à 2 et n étant un nombre entier de 2 à 5 ; MₘOₙ sélectionné de préférence parmi ZrO₂, Ta₂O₅, Nb₂O₅, Gd₂O₃, Y₂O₃, TiO₂, WO₃) ; 2) (B₂O₃, SiO₂) - La₂O₃ - MO, MO étant un oxyde métallique typiquement sélectionné parmi MgO, CaO, SrO, BaO, ZnO ; 3) SiO₂ - PbO - M₂O avec M₂O sélectionné de préférence parmi Li₂O, Na₂O, K₂O, Ca₂O ; la teneur en PbO dans les verres du système SiO₂ - PbO - M₂O étant partiellement ou totalement remplaçable par TiO₂ ; 4) SiO₂ - B₂O₃ - BaO ; 5) (SiO₂, B₂O₃) - BaO - PbO ; 6) SiO₂ - M₂O - TiO₂ (comprenant de préférence des molécules, atomes ou ions supplémentaires de fluor et/ou d'oxygène) avec M₂O étant un oxyde métallique typiquement sélectionné parmi Li₂O, Na₂O, K₂O, Ca₂O ; 7) P₂O₅ - Al₂O₃ - MO - B₂O₃ avec MO sélectionné de préférence parmi : MgO, CaO, SrO, BaO, ZnO ; 8) SiO₂ - BaO - M₂O avec M₂O sélectionné de préférence parmi Li₂O, Na₂O, K₂O, Ca₂O,
et/ou
dans lequel le matériau de la couche supérieure supplémentaire est sélectionné dans le groupe comprenant un verre de quartz, tel que SiO₂ et SiOxNy, avec x et y tels que définis dans la revendication 1 et N/(N+O) de 0 % à 50 %.

5. Procédé selon l'une quelconque des revendications 1 à 4, dans lequel la gravure comprend au moins un traitement avec un agent de gravure qui est sélectionné dans le groupe du chlore, des composés chlorés gazeux, des hydrocarbures fluorés, des fluorocarbures, de l'oxygène, de l'argon, de SF₆ et des mélanges de ceux-ci, et dans lequel chaque traitement de gravure est effectué de préférence pendant une période dans la plage de 10 s à 10 min.

6. Procédé selon la revendication 5, dans lequel la gravure comprend au moins un traitement avec un mélange de Ar/SF₆/O₂ ou Ar/SF₆ en tant qu'agent de gravure et au moins un traitement avec un mélange de Ar/CHF₃ en tant qu'agent de gravure.

7. Procédé selon l'une quelconque des revendications 1 à 6, qui comprend en outre un traitement mécanique, tel qu'une sonification, des structures en saillie générées.

8. Procédé selon l'une quelconque des revendications 1 à 7, qui comprend un traitement de gravure supplémentaire par une gravure par faisceau d'ions réactifs (RIBE), une gravure par faisceau d'ions chimiquement assistée (CAIBE), une gravure par ions réactifs (RIE) ou un plasma à couplage inductif (RIE-ICP), dans lequel les structures générées dans la couche supérieure et/ou la ou les couche(s) de médiation du substrat composite sont utilisées comme masque de gravure et des structures en saillie correspondant aux structures en saillie de la ou des couche(s) au-dessus sont générées dans le substrat primaire et la ou les couche(s) au-dessus du substrat primaire est(sont) éliminée(s) partiellement ou totalement.

9. Procédé selon l'une quelconque des revendications 1 à 8, dans lequel le substrat composite est un élément optique et les structures générées forment une structure de surface antireflet sur l'élément optique.

10. Substrat composite à surface nanostructurée comprenant
- un substrat primaire ayant un indice de réfraction défini, de préférence dans la plage de 1,3 à 2,1 ;
- une pluralité de couches de médiation ayant un indice de réfraction prédéterminé différent de celui du substrat primaire, dans lequel la séquence des couches est agencée de telle sorte qu'un gradient défini de l'indice de réfraction est fourni entre le substrat primaire et la couche la plus haute desdites couches de médiation ;
- facultativement une couche supérieure supplémentaire ;
- des nanostructures, en particulier des structures coniques ou en forme de pilier, sur la surface du substrat composite, lesquelles structures sont composées du matériau de la couche supérieure supplémentaire du substrat composite et du matériau des couches de médiation,
dans lequel le matériau de la pluralité de couches de médiation est sélectionné dans le groupe comprenant SiOx (avec 1 < x < 2) et SiOxNy (avec y/y+x dans la plage de 0 à 0,5 et avec N/(N+O) de 0 % à 50 %).

11. Substrat composite selon la revendication 10, dans lequel les structures en saillie comprennent en outre le matériau du substrat primaire.

12. Substrat composite selon la revendication 10 ou 11, dans lequel le substrat composite est un élément optique et les structures en saillie générées forment une structure de surface antireflet sur l'élément optique.

13. Substrat composite selon la revendication 11 ou 12, dans lequel les structures en saillie présentent un agencement géométrique bidimensionnel prédéterminé, en particulier un agencement hexagonal.

14. Substrat composite selon l'une quelconque des revendications 10 à 13, dans lequel le matériau du substrat primaire est sélectionné parmi les verres de quartz et les verres, comprenant en particulier l'un des systèmes de base de verres inorganiques suivants avec leurs composants principaux : 1) B₂O₃ - La₂O₃ - MₘOₙ (m étant un nombre entier de 1 à 2 et n étant un nombre entier de 2 à 5 ; MₘOₙ sélectionné de préférence parmi ZrO₂, Ta₂O₅, Nb₂O₅, Gd₂O₃, Y₂O₃, TiO₂, WO₃) ; 2) (B₂O₃, SiO₂) - La₂O₃ - MO, MO étant un oxyde métallique typiquement sélectionné parmi MgO, CaO, SrO, BaO, ZnO ; 3) SiO₂ - PbO - M₂O avec M₂O sélectionné de préférence parmi Li₂O, Na₂O, K₂O, Ca₂O ; la teneur en PbO dans les verres du système SiO₂ - PbO - M₂O étant partiellement ou totalement remplaçable par TiO₂ ; 4) SiO₂ - B₂O₃ - BaO ; 5) (SiO₂, B₂O₃) - BaO - PbO ; 6) SiO₂ - M₂O - TiO₂ (comprenant de préférence des molécules, atomes ou ions supplémentaires de fluor et/ou d'oxygène) avec M₂O étant un oxyde métallique typiquement sélectionné parmi Li₂O, Na₂O, K₂O, Ca₂O ; 7) P₂O₅ - Al₂O₃ - MO - B₂O₃ avec MO sélectionné de préférence parmi : MgO, CaO, SrO, BaO, ZnO ; 8) SiO₂ - BaO - M₂O avec M₂O sélectionné de préférence parmi Li₂O, Na₂O, K₂O, Ca₂O,
et/ou
dans lequel le matériau de la couche supérieure est sélectionné dans le groupe comprenant un verre de quartz, tel que SiO₂ et SiOxNy, avec x et y tels que définis dans la revendication 10 et N/(N+O) de 0 % à 50 %.

15. Utilisation du substrat composite selon la revendication 10 ou de l'élément optique selon la revendication 12 dans les domaines de la technologie des semi-conducteurs, de l'optique, de la technologie des capteurs et du photovoltaïque.

16. Utilisation selon la revendication 15 dans des dispositifs optiques, des capteurs, en particulier des capteurs CCD et des cellules solaires.
